(19) **Europäisches Patentamt**

**European Patent Office**

**Office européen des brevets**

(11) **EP 1 317 091 A2**

(12) **EUROPEAN PATENT APPLICATION**

(43) Date of publication:
**04.06.2003 Bulletin 2003/23**

(51) Int Cl.$^7$: **H04L 1/00**

(21) Application number: **02026866.0**

(22) Date of filing: **02.12.2002**

(84) Designated Contracting States:
**AT BE BG CH CY CZ DE DK EE ES FI FR GB GR IE IT LI LU MC NL PT SE SI SK TR**
Designated Extension States:
**AL LT LV MK RO**

(30) Priority: **01.12.2001 KR 2001075624**

(71) Applicant: **SAMSUNG ELECTRONICS CO., LTD.**
**Suwon-City, Kyungki-do (KR)**

(72) Inventors:
 • **Kim, Dong-Hee**
 **Suwon-city, Kyungki-do (KR)**

 • **Choi, Ho-Kyu**
 **Suwon-city, Kyungki-do (KR)**
 • **Kim, Youn-Sun**
 **Suwon-city, Kyungki-do (KR)**
 • **Kwon, Hwan-Joon**
 **Suwon-city, Kyungki-do (KR)**

(74) Representative: **Lang, Johannes, Dipl.-Ing.**
 **Bardehle Pagenberg Dost Altenburg Geissler Isenbruck,**
 **Postfach 86 06 20**
 **81633 München (DE)**

(54) **Encoding/decoding apparatus and method in a communication system**

(57)    An apparatus for encoding an information bit sequence and generating coded symbols in a communication system which transmits packet data and the information bit sequence for controlling transmission of the packet data. An encoder encodes the information bit sequence at a preset coding rate and outputs coded symbols. A controller controls the encoder so that the encoder outputs the coded symbols when a frame length of the information bit sequence is a first length, and the encoder outputs partial symbols among the coded symbols when the frame length of the information bit sequence is a second length, the second length being shorter than the first length.

FIG.6

**Description**

**PRIORITY**

This application claims priority to an application entitled "Encoding/Decoding Apparatus and Method in a Communication System" filed in the Korean Industrial Property Office on December 1, 2001 and assigned Serial No. 2001-75625, the contents of which are hereby incorporated by reference.

**BACKGROUND OF THE INVENTION**

1. Field of the Invention

The present invention relates generally to a communication system for packet data transmission, and in particular, to an apparatus and method for encoding/decoding transmission information.

2. Description of the Related Art

An IS-2000 CDMA (Code Division Multiple Access) mobile communication system, a typical mobile communication system, supports only a voice service. However, with the development of the communication technology and at the request of users, mobile communication systems are progressing to support a data service as well as the voice service.

A mobile communication system supporting a multimedia service including voice and data services provides the voice service to a plurality of users, using the same frequency band. Further, the mobile communication system supports the data service by TDM (Time Division Multiplexing) or TDM/CDM (Time Division Multiplexing/Code Division Multiplexing). The TDM is a technique for assigning one code within a time slot assigned to a specific user. The TDM/CDM is a technique in which a plurality of users simultaneously use one time slot. The users are identified through unique codes (e.g., orthogonal codes such as Walsh codes) assigned to the users.

The mobile communication system includes a packet data channel (PDCH) for packet data transmission and a packet data control channel (PDCCH), e.g., secondary packet data control channel (SPDCCH), for efficient transmission of packet data. Packet data is transmitted over the packet data channel. Transmission of packet data over the air is performed in a physical layer packet (PLP) unit, and a length of the physical layer packet is varied at each transmission. The packet data control channel transmits a control information frame needed to allow a receiver to efficiently receive the packet data. A length of the control information frame is changed according to a length of the packet data. Therefore, the receiver can determine a varying length of the packet data by estimating a length of the control information frame. The length of the control information frame is estimated through blind frame format detection (BFFD).

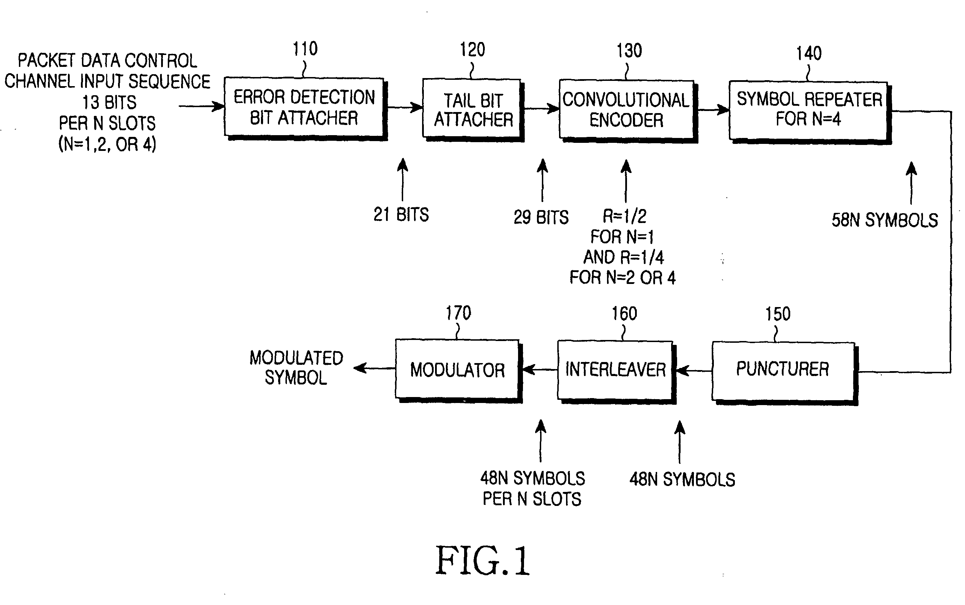

FIG. 1 illustrates a structure of a packet data control channel transmitter according to the prior art. Referring to FIG. 1, a packet data control channel input sequence, control information transmitted over a packet data control channel, is assumed to have 13 bits per N slots (where N=1, 2, or 4). It should be noted that the number of bits included in the control information is not related to a length of the control information frame, and not limited to 13. A length of the control information frame transmitted over the packet data control channel depends upon a length of the packet data. For example, if the packet data has one of 1-slot length, 2-slot length, 4-slot length and 8-slot length, then the control information frame has a selected one of 1-slot length, 2-slot length and 4-slot length. For the packet data having a 1-slot length, a control information frame having a 1-slot length is transmitted. For the packet data having a 2-slot length, a control information frame having a 2-slot length is transmitted. For the packet data having a 4-slot length, a control information frame having a 4-slot length is transmitted. For the packet data having an 8-slot length, a control information frame having a 4-slot length is transmitted. The reason for transmitting a control information frame having a 4-slot length even for the packet data having an 8-slot length is to prevent a preamble length from being excessively increased.

Error detection bits are attached by an error detection bit attacher 110 to the control information transmitted over the packet data control channel. The error detection bit attacher 110 attaches the error detection bits to the control information so that a receiver can detect a transmission error on the control information frame. For example, the error detection bit attacher 110 attaches 8 error detection bits to the 13-bit control information and generates 21-bit control information. A CRC (Cyclic Redundancy Code) generator is a typical example of the error detection bit attacher 110. The CRC generator generates CRC information-attached control information, by encoding input control information with CRC. If the number of redundancy bits generated by the CRC is increased, the capability of detecting a transmission error will be increased. However, the increase in number of the redundancy bits for the control information will reduce power efficiency. Therefore, 8 CRC bits are generally used for the error detection bits.

A tail bit attacher 120 attaches tail bits to the control information output from the error detection bit attacher 110. A convolutional encoder 130 convolutional-encodes the output of the tail bit attacher 120, and outputs coded symbols. For example, the tail bit attacher 120 attaches 8 tail bits all having 0's for convolutional encoding by the convolutional encoder 130, and outputs 29-bit information. The convolutional encoder 130 convolutional-encodes a control information frame with a 1-slot length at a coding rate 1/2, and a control information frame with a 2-slot length and a control information frame with a 4-slot length at a coding rate 1/4. The number of symbols in the control information frame convolutional-encoded at the coding rate 1/4 is two times larger than the number of symbols in the control information frame convolutional-encoded at the coding rate 1/2. A symbol repeater 140 repeatedly outputs the symbols obtained by convolutional encoding the control information frame with the 4-slot length, so that the number of symbols obtained by convolutional encoding the control information frame with a 4-slot length becomes two times larger than the number of symbols obtained by convolutional encoding the control information frame with a 2-slot length. As a result, the symbol repeater 140 outputs 58N (where N=1, 2 or 4) symbols.

A puncturer 150 punctures 10N symbols among the output symbols of the symbol repeater 140 in order to minimize performance degradation and achieve proper rate matching. Therefore, the puncturer 150 outputs 48N symbols. An interleaver 160 interleaves the output symbols of the puncturer 150. The reason for using the interleaver 160 is to reduce a burst error probability by interleaving (or permuting) the order of symbols in order to solve the burst error problem caused by convolutional encoding. A bit reverse interleaver (BRI), a kind of block interleaver, can be used for the interleaver 160. The BRI increases an interval between adjacent symbols as far as possible, such that the first half of the interleaved symbol sequence is comprised of even-numbered symbols and the second half of the interleaved symbol sequence is comprised of odd-numbered symbols. A modulator 170 modulates the symbols interleaved by the interleaver 160 by QPSK (Quadrature Phase Shift Keying) modulation, and generates modulated symbols for transmission.

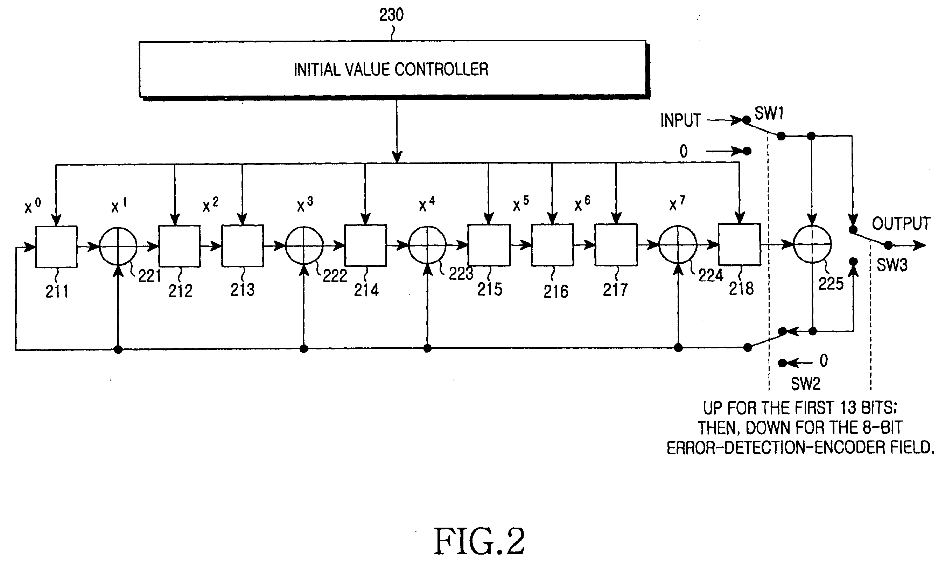

FIG. 2 illustrates a structure of the error detection bit attacher 110 shown in FIG. 1 according to the prior art. Illustrated in FIG. 2 is an example of the error detection bit attacher 110 realized with a CRC generator. The CRC generator includes a plurality of registers 211~218, a plurality of adders 221-224, switches SW1-SW3, an output adder 225, and an initial value controller 230.

Referring to FIG. 2, after values of the registers 211-218 are initialized by an initial value provided from the initial value controller 230, a binary operation is performed by the output adder 225 between each bit of the input control information and a value obtained from the final register 218 by right-shifting the values of the registers 211-218, and the operation result value is provided as output control information. During this operation, the switches SW1-SW3 are all switched to their upper terminals. After the above operation is performed on all bits of the 13-bit control information, the switches SW1-SW3 are switched to their lower terminals, so the switches SW1 and SW2 are provided with a value "0." Thereafter, 8 redundant bits are attached by shifting register values as many times as the number, i.e., 8, of the redundant bit.

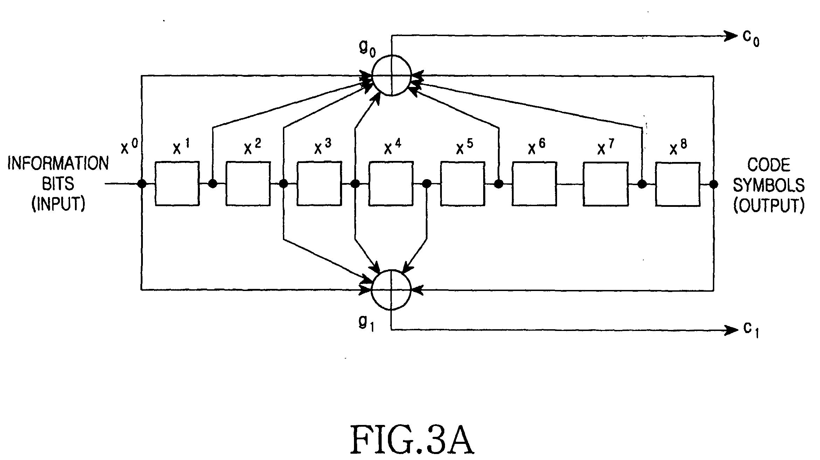

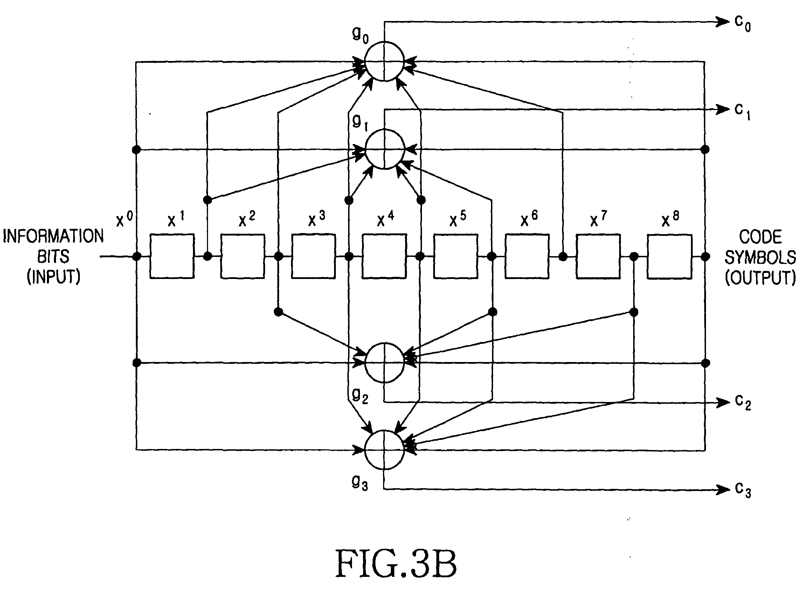

FIGs. 3A and 3B illustrate exemplary structures of the convolutional encoder 130 shown in FIG. 1. Specifically, FIG. 3A illustrates an exemplary structure for convolutional-encoding input information bits at a coding rate R=1/2 and outputting coded symbols. FIG. 3B illustrates another exemplary structure for convolutional-encoding input information bits at a coding rate R=1/4 and outputting coded symbols.

Referring to FIG. 3A, if a coding rate is R=1/2 and a sequence of input information bits is defined as x, then outputs $2\text{-}C_0$ and $2\text{-}C_1$ of the convolutional encoder 130 are expressed as

$$2\text{-}C_0: 1+x+x^2+x^3+x^5+x^7+x^8$$

$$2\text{-}C_1: 1+x^2+x^3+x^4+x^8$$

Referring to FIG. 3B, if a coding rate is R=1/4 and a sequence of input information bits is defined as x, then outputs $4\text{-}C_0$, $4\text{-}C_1$, $4\text{-}C_2$, and $4\text{-}C_3$ of the convolutional encoder 130 are expressed as

$$4\text{-}C_0: 1+x+x^2+x^3+x^4+x^6+x^8$$

$$4\text{-}C_1: 1+x+x^3+x^4+x^5+x^8$$

$$4\text{-}C_2: 1+x^2+x^5+x^7+x^8$$

$$4\text{-}C_3: 1+x^3+x^4+x^5+x^7+x^8$$

In the above expressions, Cs stands for one of the outputs of the convolutional encoder 130, where s indicates the order of the output symbols of the convolutional encoder 130, and '2' or '4' indicates the number of the output symbols of the convolutional encoder 130.

In order to generate such coded symbols, it is necessary to design the convolutional encoder 130 of FIG. 3A or 3B according to predetermined codeword symbol generator polynomials. As illustrated, the convolutional encoder 130 can be realized by combining registers and adders. Codeword symbol generator polynomials for the coding rates are determined such that they can show optimal performance at the respective coding rates. That is, generator polynomials for a convolutional encoder with a coding rate R=1/2 (hereinafter, referred to as an R=1/2 convolutional encoder) and generator polynomials for a convolutional encoder with a coding rate R=1/4 (hereinafter, referred to as an R=1/4 convolutional encoder) are determined to be independent of one another.

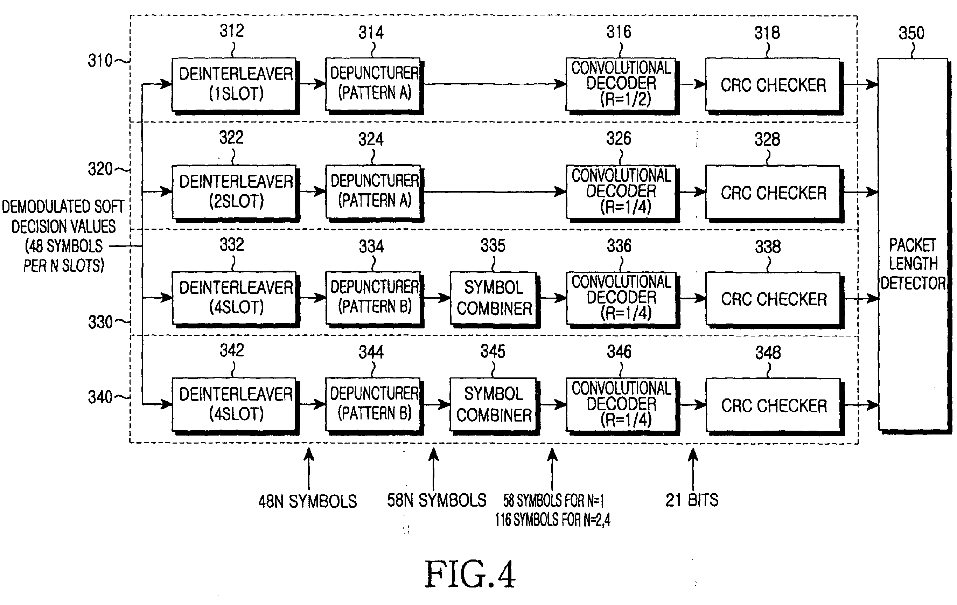

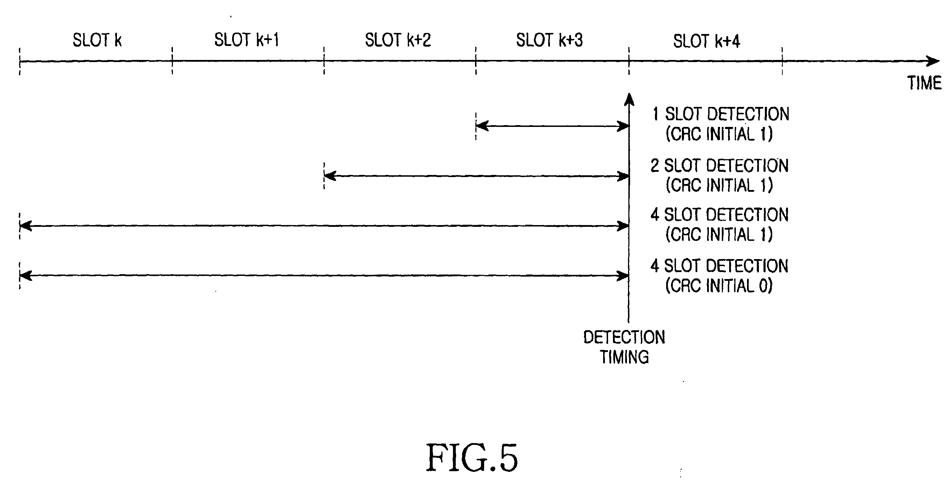

FIG. 4 illustrates a structure of a packet data control channel receiver according to the prior art, and FIG. 5 illustrates lengths and positions of slots used when detecting a control information frame by the receiver of FIG. 4. In particular, FIG. 4 illustrates a structure of a receiver for detecting a length of packet data by detecting a control information frame transmitted over a packet data control channel by BFFD. The receiver corresponds to the packet data control channel transmitter in which a CRC generator is used as an error detection bit attacher. The receiver includes CRC checkers corresponding to the CRC generator in the transmitter.

Referring to FIG. 4, the receiver includes 4 reception processing blocks 310-340 for detecting a length of packet data. The reception processing block 310 is a block for processing a control information frame with a 1-slot length corresponding to packet data with a 1-slot length, the reception processing block 320 is a block for processing a control information frame with a 2-slot length corresponding to packet data with a 2-slot length, the reception processing block 330 is a block for processing a control information frame with a 4-slot length corresponding to packet data with a 4-slot length, and the reception processing block 340 is a block for processing a control information frame with a 4-slot length corresponding to packet data with an 8-slot length.

In the reception processing blocks 310-340, deinterleavers 312, 322, 332 and 342 perform deinterleaving as much as the corresponding slot lengths, and depuncturers 314, 324, 334 and 344 perform depuncturing according to the corresponding slot lengths. In the reception processing blocks 330 and 340 for the control information frame with the 4-slot length, symbol combiners 335 and 345 perform symbol combining on 2 adjacent symbols, which is a reverse operation of the symbol repetition performed by the symbol repeater 140 of FIG. 1. After the depuncturing is performed in the reception processing blocks 310 and 320 and the symbol combining is performed in the reception processing blocks 330 and 340, convolutional decoders 316, 326, 336 and 346 in the reception processing blocks 310-340 perform convolutional decoding. The convolutional decoder 316 for the control information frame with the 1-slot length convolutional-decodes an output of the depuncturer 314 at a coding rate 1/2. The convolutional decoder 326 for the control information frame with the 2-slot length convolutional-decodes an output of the depuncturer 324 at a coding rate 1/4. Likewise, the convolutional decoders 336 and 346 for the control information frame with the 4-slot length convolutional-decode outputs of the symbol combiners 335 and 345 at a coding rate 1/4, respectively. In final stages of the reception processing blocks 310-340, CRC checkers 318, 328, 338 and 348 are arranged. The CRC checkers 318, 328, 338 and 348 perform CRC checking on the symbols convolutional-decoded by the convolutional decoders 316, 326, 336 and 346, respectively. From the CRC checking by the CRC checkers 318, 328, 338 and 348, it is determined whether a CRC error exists in the control information frame transmitted from the transmitter. During the CRC checking, the CRC checkers 318, 328, 338 and 348 use predetermined initial values. For example, the CRC checker 318 detects a CRC error by setting an initial value of a decoder register to "2," the CRC checker 328 detects a CRC error by setting an initial value of a decoder register to "4," the CRC checker 338 detects a CRC error by setting an initial value of a decoder register to "255," and the CRC checker 348 detects a CRC error by setting an initial value of a decoder register to "0." A packet length detector 350 detects a length of packet data based on the reception processing results by the reception processing blocks 310-340. Here, the 4 reception processing blocks 310-340 can be realized with either physically separated reception processing blocks or a single reception processing block using different reception parameters.

In the receiver of FIG. 4, as a result of CRC decoding, if three reception processing blocks have errors and one reception processing block has no error, it is judged that as much packet data as a length corresponding to the error-free reception processing block was transmitted. However, if it is reported that two or more reception processing blocks have no error or all reception processing blocks have no error, it is not possible to determine which control information frame was transmitted, resulting in a failure to receive packet data.

Table 1 illustrates computer simulation results obtained by transmitting a control information frame with a slot length of 2(4) 10,000 times in a noise-free state and receiving the transmitted control information frame by receivers of 1(2), 2(4), 4(255) and 4(0). Here, numerals in the parenthesis represent register initial values of the CRC generator in terms of decimal numbers. For a control information frame with a 1-slot length, a register initial value is set to N1=2. For a control information frame with a 2-slot length, a register initial value is set to N2=4. For a control information frame with a 4-slot length corresponding to packet data with a 4-slot length, a register initial value is set to N3=255. For a control information frame with a 4-slot length corresponding to packet data with an 8-slot length, a register initial value is set to N4=0. The result values obtained through the computer simulation include a successful detection probability Pd, a false probability Pfa of recognizing an incorrect slot length as a correct slot length, a mis-probability Pm of mistaking a correct slot length for an incorrect slot length, and an error probability Pe, the sum of the false probability Pfa and the mis-probability Pm. It is noted in Table 1 that the error probability Pe of a control information frame is mostly generated by a 1-slot control information frame receiver.

Table 1

| SPDCCH (CRC) | Pd | Pfa | Pm | Pe |
|---|---|---|---|---|
| 2(4) | 9.936e-01 | 0.000e+00 | 6.400e-03 | 6.400e-03 |

| SPDCCH (CRC) | CRC success | | | | Dedicated to other CRC symbols | | | |
|---|---|---|---|---|---|---|---|---|
| | 1(2) | 2(4) | 4(255) | 4(0) | 1(2) | 2(4) | 4(255) | 4(0) |
| 2(4) | 45 | 10000 | 7 | 12 | 45 | 0 | 7 | 12 |

As described above, the packet data control channel transmitter of FIG. 1 uses the same convolutional encoders with a coding rate 1/4, for both a 2-slot control information frame and a 4-slot control information frame, and uses a convolutional encoder with a coding rate 1/2 for a 1-slot control information frame. In this case, if a packet data control channel receiver receives a control information frame by BFFD, an error probability Pe of a 2-slot control information frame is undesirably increased due to an error by a 1-slot control information frame receiver which has almost all error probability in the receiver, as described in conjunction with Table 1.

**SUMMARY OF THE INVENTION**

It is, therefore, an object of the present invention to provide an encoding/decoding apparatus and method for eliminating an error which may occur during transmission/reception of control information related to transmission packet data in a communication system.

It is another object of the present invention to provide an encoding/decoding apparatus and method for correctly receiving control information even though a length of the control information related to transmission packet data is changed, in a communication system.

According to a first aspect of the present invention, there is provided an apparatus for encoding an information bit sequence and generating coded symbols in a communication system which transmits packet data and the information bit sequence for controlling transmission of the packet data. The apparatus in one embodiment includes an encoder and a controller. The encoder encodes the information bit sequence at a preset coding rate and outputs coded symbols. The controller controls the encoder so that the encoder outputs the coded symbols when a frame length of the information bit sequence is a first length, and the encoder outputs partial symbols among the coded symbols when the frame length of the information bit sequence is a second length being shorter than the first length. Preferably, the controller controls the encoder so that the encoder outputs as many coded symbols as a number determined by dividing the number of the coded symbols by a predetermined number F (where F is a natural number), when the frame length of the information bit sequence is a second length being F times shorter than the first length.

According a second aspect of the present invention, there is provided an apparatus for encoding an information bit sequence and generating coded symbols in a communication system which transmits packet data and the information bit sequence for controlling transmission of the packet data. The apparatus in one embodiment includes an error detection bit attacher, a convolutional encoder, and a controller. The error detection bit attacher attaches error detection bits to the information bit sequence and outputs the error detection bit-attached information bit sequence. The convolutional encoder convolutional-encodes the error detection bit-attached information bit sequence at a preset coding rate, and outputs coded symbols. The controller controls the convolutional encoder so that the convolutional encoder outputs the coded symbols when a frame length of the information bit sequence is a first length, and the convolutional encoder outputs as many coded symbols as a number determined by dividing the number of the coded symbols by a predetermined number F (where F is a natural number), when the frame length of the information bit sequence is a second length being F times shorter than the first length.

**BRIEF DESCRIPTION OF THE DRAWINGS**

The above and other objects, features and advantages of the present invention will become more apparent from the following detailed description when taken in conjunction with the accompanying drawings in which:

FIG. 1 illustrates a structure of a packet data control channel transmitter according to the prior art;
FIG. 2 illustrates a structure of the error detection bit attacher shown in FIG. 1 according to the prior art;
FIGs. 3A and 3B illustrate exemplary structures of the convolutional encoder shown in FIG. 1;
FIG. 4 illustrates a structure of a packet data control channel receiver according to the prior art;
FIG. 5 illustrates lengths and positions of slots used when detecting a control information frame by the receiver of FIG. 4;
FIG. 6 illustrates a structure of a convolutional encoder apparatus according to an embodiment of the present invention;
FIG. 7 illustrates a detailed structure of the error detection bit attacher shown in FIG. 1 according to an embodiment of the present invention;
FIG. 8 illustrates a structure of a convolutional decoder apparatus according to an embodiment of the present invention; and
FIG. 9 illustrates a detailed structure of the CRC checker shown in FIG. 4 according to an embodiment of the present invention.

**DETAILED DESCRIPTION OF THE PREFERRED EMBODIMENT**

A preferred embodiment of the present invention will be described herein below with reference to the accompanying drawings. In the following description, well-known functions or constructions are not described in detail since they would obscure the invention in unnecessary detail.
When a conventional packet data control channel transmitter uses a convolutional encoder in order to generate codeword symbols of a 2-slot control information frame encoded at a coding rate 1/4, outputs $4\text{-}C_0$ and $4\text{-}C_2$ of the convolutional encoder are located in a first slot and outputs $4\text{-}C_1$ and $4\text{-}C_3$ of the convolutional encoder are located in a second slot. That is, if two generator polynomials are selected as generator polynomials for an R=1/2 convolutional encoder for encoding a 1-slot control information frame among generator polynomials for an R=1/4 convolutional encoder, instead of using generator polynomials different from the generator polynomials for the R=/14 convolutional encoder, there is a high probability that a receiver for a 1-slot control information frame and a receiver for a 2-slot control information frame will generate the same outputs at their convolutional decoders. Although the convolutional decoders generate the same outputs, received symbols can be identified by different CRC register initial values used in CRC checkers following the individual convolutional decoders. That is, although the convolutional decoders generate the same outputs, when one receiver has "Good" CRC check result, another receiver has 100% "Bad" CRC check result, thus reducing a BFFD error which may occur when both of the two receivers simultaneously have "Good" CRC check result.
In other words, the currently used generator polynomials for the R=1/2 convolutional encoder are not optimal generator polynomials in terms of BFFD performance, and in order to maximize the BFFD performance, it is necessary to select two generator polynomials among generator polynomials for convolutional-encoding a 2-slot control information frame at a coding rate R=1/4, as generator polynomials for convolutional-encoding a 1-slot control information frame at a coding rate R=1/2.

Principle

A method for generating coded symbols in a manner described below, in a communication system which encodes an input information bit sequence and generates the coded symbols is proposed. The proposed method can be applied to the convolutional encoder 130 of FIG. 1.
The invention provides a method for encoding an input information bit sequence with a first length at a first coding rate, and outputting coded symbols. In addition, the present invention provides a method for encoding an input information bit sequence with a second length being a predetermined number, F times shorter than the first length, at the first coding rate, and selecting several (1/F) coded symbols among the coded symbols. The input information bit sequence, as described in the prior art and herein below, may become control information related to transmission of packet data. It is assumed that there are some packets with different lengths and the ratio of packet lengths is 1:2:4 in the communication system, For the same information bit sequence, since each packet has a different coding rate, ratio of which is 1:1/2:1/4 the length of transmission packets is different from each other in accordance with the coding rate. The predetermined number F is determined by considering the length of the transmission packet. For example, the input information bit sequence with the first length may become a 2-slot control information frame, and the input information bit sequence with the second length may become a 1-slot control information frame. In this case, the first coding rate may become 1/4 and the second coding rate may become 1/2. The several coded symbols selected among coded symbols obtained by encoding the input information bit sequence with the second length at the first coding rate R=1/4 may become odd-numbered symbols or even-numbered symbols among the symbols coded at the first coding rate. Alternatively, the selected partial coded symbols may become the first half or the second half of the symbols coded at the first coding rate.

It will be assumed herein that the principle of the present invention is applied to the case where the convolutional encoder 130 of FIGs 3A and 3B generates convolutional-encoded symbols. That is, the convolutional encoder 130 encodes a 1-slot control information frame at a coding rate R=1/4, and then selects only some of the coded symbols. In Case 1, Case 2, Case 3 and Case 4 below, the symbols encoded by the convolutional encoder 130 are represented by $4\text{-}C_0$, $4\text{-}C_1$, $4\text{-}C_2$ and $4\text{-}C_3$, and the partial symbols selected among the coded symbols are represented by $2\text{-}C_0$ and $2\text{-}C_1$.

Case 1
$2\text{-}C_0$: $4\text{-}C_0$ (or $4\text{-}C_2$)
$2\text{-}C_1$: $4\text{-}C_2$ (or $4\text{-}C_0$)

Case 2
$2\text{-}C_0$: $4\text{-}C_1$ (or 4-C3)
$2\text{-}C_1$: $4\text{-}C_3$ (or $4\text{-}C_1$)

Case 3
$2\text{-}C_0$: $4\text{-}C_0$ (or $4\text{-}C_1$)
$2\text{-}C_1$: $4\text{-}C_1$ (or $4\text{-}C_0$)

Case 4
$2\text{-}C_0$: $4\text{-}C_2$ (or $4\text{-}C_3$)
$2\text{-}C_1$: $4\text{-}C_3$ (or $4\text{-}C_2$)

In Case 1 to Case 4, $4\text{-}C_0$, $4\text{-}C_1$, $4\text{-}C_2$ and $4\text{-}C_3$ are outputs of an R=1/4 convolutional encoder, and generator polynomials for these outputs can be previously determined as follows. As shown below, generator polynomials for generating codeword symbols of $4\text{-}C_0$, $4\text{-}C_1$, $4\text{-}C_2$ and $4\text{-}C_3$ can be replaced with other generator polynomials on condition that optimal coding performance is satisfied.

$$4\text{-}C_0: 1+x+x^2+x^3+x^4+x^6+x^8$$

$$4\text{-}C_1: 1+x+x^3+x^4+x^5+x^8$$

$$4\text{-}C_2: 1+x^2+x^5+x^7+x^8$$

$$4\text{-}C_3: 1+x^3+x^4+x^5+x^7+x^8$$

Meanwhile, when error detection information is attached by a CRC generator to each of a 1-slot control information frame and a 2-slot control information frame, it is preferable to set initial values of CRC registers to different values.

Embodiment

The present invention will be described with reference to an embodiment where the principle of the invention is applied to a transmitter for encoding control information related to transmission of packet data by a convolutional encoder as illustrated in FIGs. 1 and 2, before transmission, and a receiver for performing decoding by a convolutional decoder corresponding to the convolutional encoder. However, it should be noted that the present invention is not restricted to such an embodiment. The proposed method for encoding information bits such as a control information frame related packet data transmission, before transmission, and decoding received codeword symbols is characterized by selecting, as generator polynomials for encoding a 1-slot control information frame, partial generator polynomials among generator polynomials for encoding a 2-slot control information frame. In addition, the embodiment of the present invention is featured by using different register initial values when attaching error detection information to a 1-slot control information frame and a 2-slot control information frame by a CRC generator.

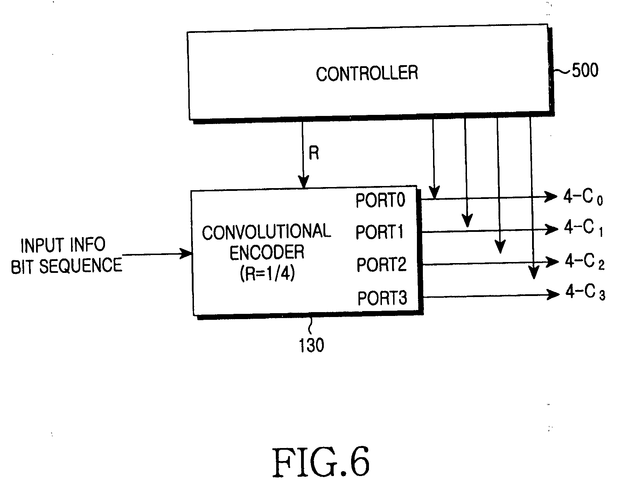

FIG. 6 illustrates a structure of a convolutional encoder apparatus according to an embodiment of the present invention. Referring to FIG. 6, the convolutional encoder apparatus includes a convolutional encoder 130 and a controller 500. The convolutional encoder 130 encodes an input information bit sequence at a preset coding rate R=1/4, and outputs the coded symbols through as many output ports PORT0-PORT3 as a number corresponding to the coding rate. The controller 500 determines a length of the input information bit sequence and performs an operation corresponding to the determined length. If the input information bit sequence is a 1-slot control information frame, the controller 500 activates the output ports so that the coded symbols should be output through two of the output ports. If the input information bit sequence is a 2-slot control information frame, the controller 500 activates the output ports so that the coded symbols should be output through the 4 output ports. Specifically, if the input information bit sequence is a 1-slot control information frame, the controller 500 activates odd-numbered output ports $4\text{-}C_0$ and $4\text{-}C_2$, even-numbered output ports $4\text{-}C_1$ and $4\text{-}C_3$, first-half output ports $4\text{-}C_0$ and $4\text{-}C_1$, or second-half output ports $4\text{-}C_2$ and $4\text{-}C_3$, among the output ports. Preferably, the controller 500 activates odd-numbered output ports $4\text{-}C_0$ and $4\text{-}C_2$ or even-numbered output ports $4\text{-}C_1$ and $4\text{-}C_3$ among the output ports.

In this way, when a 1-slot control information frame is transmitted, the controller 500 uses, for encoding, only two of the 4 code generator polynomials used in the R=1/4 convolutional encoder 130, and also activates only the output ports corresponding to the 2 generator polynomials in use among the 4 output ports. However, when a 2-slot or 4-slot control information frame is transmitted, the controller 500 uses all of the 4 code generator polynomials used in the R=1/4 convolutional encoder.

Although the present invention has been described with reference to an example of encoding a 1-slot frame corresponding to a coding rate R=1/2 by an R=1/4 convolutional encoder, the present invention may be applied to another example. For example, when encoding is performed at a coding rate R=1/6, only 3 generator polynomials out of 6 code generator polynomials can be used to encode a 1-slot frame corresponding to a coding rate R=1/3. That is, the present invention is not restricted to a particular coding rate. In addition, in order to use the same encoder for the channels having different frame structures, it is also possible to use a predetermined number of output ports, instead of using only half of the possible output ports.

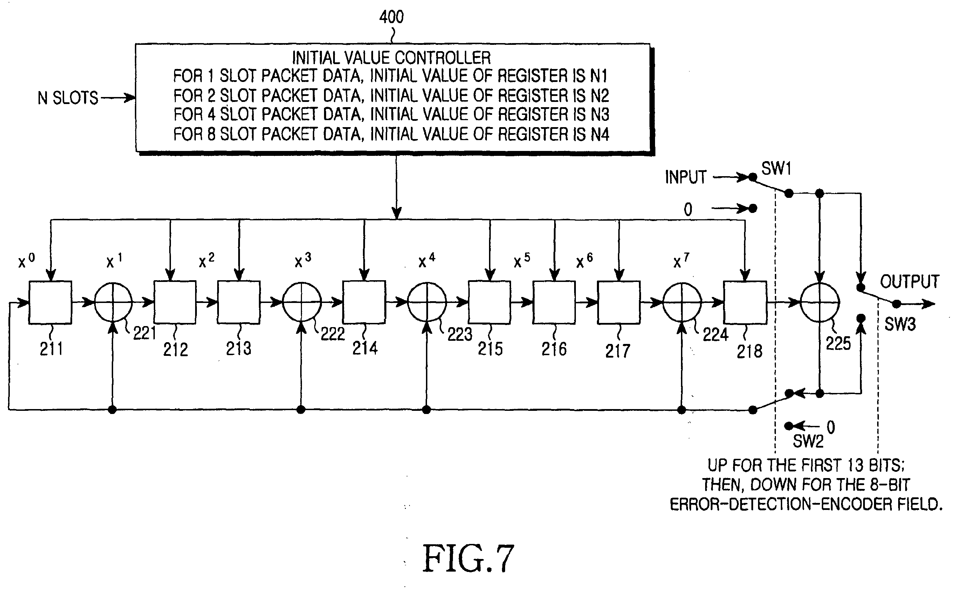

FIG. 7 illustrates a detailed structure of the error detection bit attacher 110 shown in FIG. 1 according to an embodiment of the present invention. Illustrated in FIG. 7 is an example of the error detection bit attacher 110 realized with a CRC generator, the error detection bit attacher 110 corresponding to the CRC generator illustrated in FIG. 2. The CRC generator according to the present invention sets different register initial values for control information frames supporting data packets with different lengths, regardless of a length of the control information frames. For example, when attaching 8 error detection bits to a control information frame, the CRC generator sets "1" or "0" for each of 8 registers thereof. In decimal, the 8 registers are set to an initial value of 0 to 255 (=$2^8$-1). That is, if the number of registers constituting the CRC generator (or the number of redundant information bits for error detection) is m, registers of the CRC generator can be set to an initial value of 0 to $2^m$-1 in decimal. For example, initial values N1, N2, N3 and N4 of CRC generator's registers, to be used to transmit a 1-slot control information frame for 1-slot packet data, a 2-slot control information frame for 2-slot packet data, a 4-slot control information frame for 4-slot packet data and a 4-slot control information frame for 8-slot packet data, can be set to a particular value between 0 to 255. Here, N1 and N2 are set to different values.

Referring to FIG. 7, the error detection bit attacher 110 according to an embodiment of the present invention includes a plurality of registers 211-218, a plurality of adders 221-224, switches SW1-SW3, an output adder 225, and an initial value controller 400. The initial value controller 400 initializes values of the registers 211-218 to N1 when packet data with a 1-slot length is transmitted. The initial value controller 400 initializes values of the registers 211-218 to N2 when packet data with a 2-slot length is transmitted. The initial value controller 400 initializes values of the registers 211-218 to N3 when packet data with a 4-slot length is transmitted. The initial value controller 400 initializes values of the registers 211-218 to N4 when packet data with an 8-slot length is transmitted.

After the values of the registers 211-218 are initialized, a binary operation (or exclusive OR operation or modulo-2 operation) is performed by the output adder 225 between each bit of the input control information and a value finally obtained from the register 218 by right-shifting the values of the registers 211-218, and the operation result value is generated as a feedback bit sequence. The generated feedback bit sequence is provided as an input of the initial register 211 among the registers 211-218 and an input of the adders 221-224. During this operation, the switches SW1-SW3 are all switched to their upper terminals. After the above operation is performed on all bits of the 13-bit control information frame, the switches SW1-SW3 are switched to their lower terminals, so the switches SW1-SW3 are provided with a value "0." Thereafter, 8 redundant bits are attached by shifting the register values as many times as the number of the redundant bit, i.e., 8.

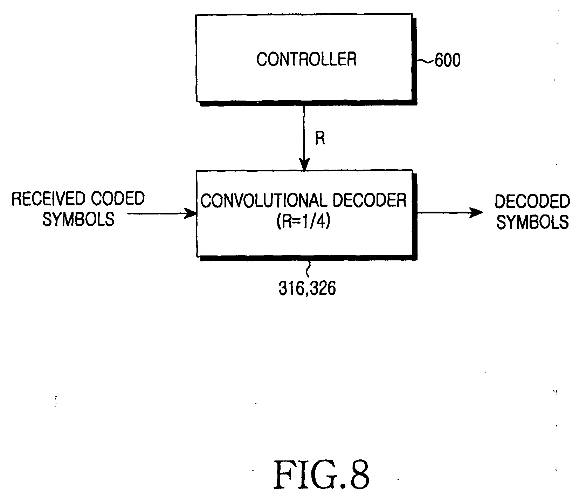

FIG. 8 illustrates a structure of a convolutional decoder apparatus according to an embodiment of the present invention. Referring to FIG. 8, the convolutional decoder apparatus includes a convolutional decoder 316 (or 326) and a controller 600. That is, the convolutional decoder serves as the convolutional decoder 316 or the convolutional decoder 326 of FIG. 4.

The convolutional decoder receives coded symbols included in a received signal, and decodes the received coded symbols according to a coding rate R provided from the controller 600. The convolutional decoder 316 of FIG. 4 performs decoding at a coding rate R=1/2, and the convolutional decoder 326 performs decoding at a coding rate R=1/4. However, the convolutional decoder illustrated in FIG. 8 performs decoding according to a coding rate R (e.g., R=1/4) provided from the controller 600. The controller 600 selects code generator polynomials according to a slot length of a control information frame for packet data. That is, when transmitting a 1-slot frame, the controller 600 selects, for decoding, only two generator polynomials out of 4 code generator polynomials to be used for an R=1/4 convolutional decoder. Unlike this, when transmitting a 2-slot frame or a 4-slot frame, the controller 600 selects, for decoding, all of the 4 code generator polynomials to be used for an R=1/4 convolutional decoder. The controller 600 determines the slot length by BFFD. That is, when a receiver serves as the receiver 310 of FIG. 4, the controller 600 determines that a slot length of a packet control frame is 1. When a receiver serves as the receiver 320 of FIG. 4, the controller 600 determines that a slot length of a packet control frame is 2. When a receiver serves as the receiver 330 or 340 of FIG. 4, the controller 600 determines that a slot length of a packet control frame is 4.

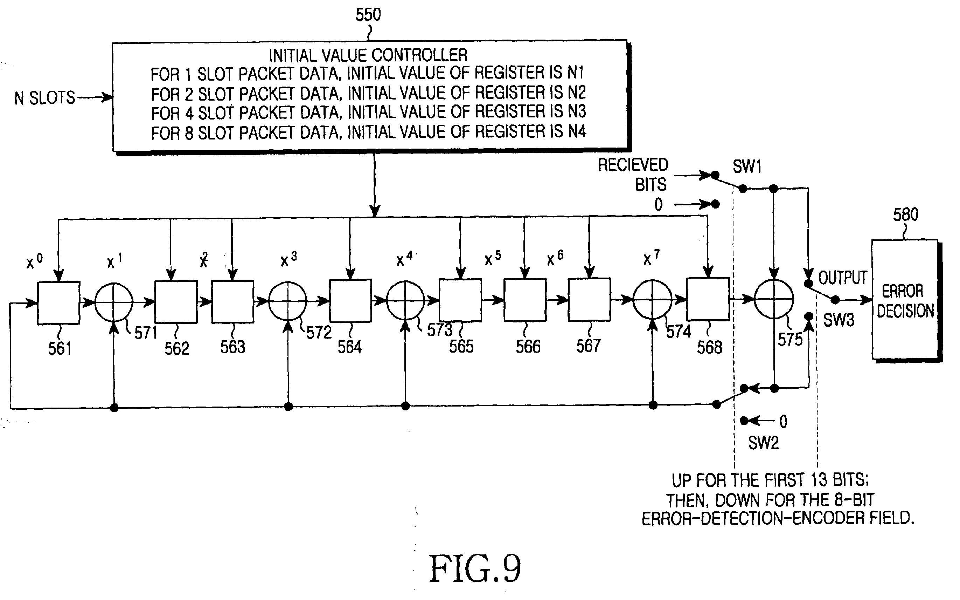

FIG. 9 illustrates a detailed structure of the CRC checker 318 (or 328) shown in FIG. 4 according to an embodiment of the present invention. This apparatus corresponds to the error detection bit attacher 110 (FIG. 1) shown in FIG. 7 in detail, and performs the same operation as the error detection bit attacher 110. However, this apparatus is different from the error detection bit attacher 110 in that received bits are applied to SW1. Particularly, in the CRC checker 318 (or 328), a CRC register initial value used for CRC check on a 1-slot control frame and a CRC register initial value used for CRC check on a 2-slot control frame are set to different values.

Referring to FIG. 9, the CRC checker according to an embodiment of the present invention includes a plurality of registers 561-568, a plurality of adders 571-574, an output adder 575, switches SW1-SW3, an initial value controller 550, and an error decision block 580. The initial value controller 550 provides a first initial value for first information (e. g., 1-slot control information frame) or a second initial value for second information (e.g., 2-slot control information frame), as a value for initializing the registers. The provided initial values are determined according to a length (N slots) of the packet data. Preferably, the first initial value and the second initial value are determined within a range of a value corresponding to the number of the attached error detection information bits.

The registers 561-568, the number of which is identical to the number of the attached error detection information bits, are cascaded and initialized to corresponding initial values provided from the initial value controller 550. The adders 571-574 are arranged on paths determined by a predetermined generator polynomial among the paths between the registers 561-568. Each of the adders 571-574 adds an input bit sequence received through an input path to a feedback bit sequence, and provides its output through an output path. The feedback bit sequence refers to a bit sequence output from the output adder 575 through the second switch SW2.

The output adder 575 and the switches SW1-SW3 constitute an operator for performing the following operation. The operator, while receiving a received information sequence (the first information or second information), generates the feedback bit sequence by sequentially adding bits of the received information sequence to output bits of the final register 568, and provides the generated feedback bit sequence to the adders 571-574 and the initial register 561 through the second switch SW2. Further, the operator, after completing reception of the received information sequence, provides the preset input bit .0. to the adders 571-574 and the initial register 561 through the second switch SW2, sequentially adds the preset input bit 0. to output bits of the final register 568 by the output adder 575, and outputs the addition result as a received error detection information bit sequence.

The first switch SW1 selects the received information sequence or the preset input bit 0. The first switch SW1 outputs the received information sequence while receiving the received information sequence, and outputs the preset input bit .0. after completion of receiving the received information sequence. The output adder 575 adds an output of the first switch SW1 to output bits of the final register 568. The second switch SW2 selects the output of the output adder 575 or the preset input bit. 0,. and provides the selected value to the adders 571-574 and the initial register 561, as a feedback bit sequence. The second switch SW2 provides the output of the output adder 575 to the adders 571-574 and the initial register 561 during reception of the received information sequence, and provides the preset input bit .0. to the adders 571-574 and the initial register 561 after completing reception of the received information sequence. The third switch SW3 selects the received information sequence or the output bit sequence, i.e., the received error detection information bit sequence, of the output adder 575. The third switch SW3 outputs the received information sequence during reception of the received information sequence, and outputs the received error detection information bit sequence provided from the output adder 575 after completing reception of the received information sequence.

The error decision block 580 compares the received error detection information bit sequence with an error detection information bit sequence corresponding to the selected initial value, thus to determine whether an error exists in the received bits. That is, the error decision block 580 decides that no error exists in the received bits, if the received error detection information bit sequence is identical to the error detection information bit sequence corresponding to the selected initial value. Otherwise, if the received error detection information bit sequence is not identical to the error detection information bit sequence corresponding to the selected initial value, the error decision block 580 decides that an error exists in the received bits. Based on the decision result by the error decision block 580, the packet length detector 350 of FIG. 4 can detect a length of the received bits.

As described above, in the apparatus of FIG. 9, the initial value controller 550 operates according to a length of the packet data. When first 13 bits of the received bits transmitted from the transmitter are completely received, the switches SW1-SW3 are switched to their lower terminals, so the switches SW1-SW3 are provided with the preset input bit "0." Thereafter, 8 error detection bits (or redundant bits) are generated by shifting register values as many times as the number of the error detection bits, i.e., 8. The error detection block 580 compares error detection bits (attached by the transmitter) included in the received bits with newly generated error detection bits. The error detection block 580 decides that no error exists in the received bits, if the error detection bits included in the received bits are identical to the newly generated error detection bits. However, if the error detection bits included in the received bits are not identical to the newly generated error detection bits, the error detection block 580 decides that an error exists in the received bits. Although the initial value controller 550 and the error detection block 580 are separately constructed in this embodiment, the elements may be realized by a single controller.

Table 2 illustrates computer simulation results obtained by transmitting a control information frame with a slot length of 2(4) 10,000 times in a noise-free state and receiving the transmitted control information frame by receivers of 1(2), 2(4), 4(255) and 4(0), according to an embodiment of the present invention. Comparing Table 2 with Table 1, it is noted that an error probability due to a 1-slot control information frame is remarkably reduced, causing a decrease in error probability of a 2-slot control information frame.

Table 2

| SPDCCH (CRC) | Pd | Pfa | Pm | Pe |
|---|---|---|---|---|
| 2(4) | 9.962e-001 | 0.000e+000 | 3.800e-003 | 3.800e-003 |

| SPDCCH (CRC) | CRC success | | | | Dedicated to other CRC symbols | | | |
|---|---|---|---|---|---|---|---|---|
| | 1(2) | 2(4) | 4(255) | 4(0) | 1(2) | 2(4) | 4(255) | 4(0) |
| 2(4) | 22 | 10000 | 15 | 1 | 22 | 0 | 15 | 1 |

As described above, when encoding a second information bit sequence having a second length being shorter than a first length of a first information bit sequence, the present invention selects only partial symbols among the symbols encoded at a first coding rate used for encoding the first information bit sequence with the first length. By dong so, the present invention increases a probability that a receiver for the information bit sequence with the first length and a receiver for the information bit sequence with the second length will generate the same decoding outputs. Although the same decoding outputs are generated, received symbols can be identified by different CRC register initial values used in the CRC checkers. That is, when one receiver has "Good" CRC check result, another receiver has 100% "Bad" CRC check result, thus reducing a BFFD error which may occur when both of the two receivers simultaneously have "Good" CRC check result.

While the invention has been shown and described with reference to a certain preferred embodiment thereof, it will be understood by those skilled in the art that various changes in form and details may be made therein without departing from the spirit and scope of the invention as defined by the appended claims.

# EP 1 317 091 A2

**Claims**

1. An apparatus for encoding an information bit sequence and generating coded symbols in a communication system which transmits packet data and the information bit sequence for controlling transmission of the packet data, the apparatus comprising:

   an encoder for encoding the information bit sequence at a preset coding rate and outputting coded symbols; and
   a controller for controlling the encoder so that the encoder outputs the coded symbols when a frame length of the information bit sequence is a first length, and the encoder outputs partial symbols among the coded symbols when the frame length of the information bit sequence is a second length, the second length being shorter than the first length.

2. The apparatus of claim 1, wherein the controller controls the encoder so that the encoder outputs as many coded symbols as a number determined by dividing a number of the coded symbols by a predetermined natural number F, when the frame length of the information bit sequence is a length that is F times shorter than the first length.

3. The apparatus of claim 1, wherein the preset coding rate is equal to a coding rate determined for encoding of the information bit sequence having the first length.

4. The apparatus of claim 1, wherein the encoder is a convolutional encoder.

5. The apparatus of claim 1, further comprising an error detection bit attacher for attaching error detection bits generated by a predetermined generator polynomial to the information bit sequence, and providing the error detection bit-attached information bit sequence to the encoder.

6. The apparatus of claim 5, wherein an initial value of the predetermined generator polynomial is determined according to a frame length of the information bit sequence.

7. An apparatus for encoding an information bit sequence and generating coded symbols in a communication system which transmits packet data and the information bit sequence for controlling transmission of the packet data, the apparatus comprising:

   an error detection bit attacher for attaching error detection bits to the information bit sequence and outputting the error detection bit-attached information bit sequence;
   a convolutional encoder for convolutional-encoding the error detection bit-attached information bit sequence at a preset coding rate, and outputting coded symbols; and
   a controller for controlling the convolutional encoder so that the convolutional encoder outputs the coded symbols when a frame length of the information bit sequence is a first length, and the convolutional encoder outputs as many coded symbols as a number determined by dividing a number of the coded symbols by a predetermined natural number F, when the frame length of the information bit sequence is a second length that is F times shorter than the first length.

8. The apparatus of claim 7, wherein the preset coding rate is equal to a coding rate determined for encoding of the information bit sequence having the first length.

9. The apparatus of claim 7, wherein the information bit sequence having a frame length of the first length is an information bit sequence having the second slot length.

10. The apparatus of claim 9, wherein the preset coding rate is 1/4.

11. The apparatus of claim 7, wherein the error detection bit attacher attaches error detection bits generated by a predetermined generator polynomial to the information bit sequence.

12. The apparatus of claim 11, wherein an initial value of the predetermined generator polynomial is determined according to a frame length of the information bit sequence.

13. A method for encoding an information bit sequence and generating coded symbols in a communication system which transmits packet data and the information bit sequence for controlling transmission of the packet data, the method comprising the steps of:

encoding the information bit sequence at a preset coding rate and outputting coded symbols; and
outputting the coded symbols as output symbols when a frame length of the information bit sequence is a first length, and outputting, as output symbols, partial symbols among the coded symbols when the frame length of the information bit sequence is a second length that is shorter than the first length.

**14.** The method of claim 13, wherein the number of the partial symbols is determined by dividing a number of the coded symbols by a predetermined natural number F, when the frame length of the information bit sequence is the second length that is F times shorter than the first length.

**15.** The method of claim 13, wherein the preset coding rate is equal to a coding rate determined for encoding of the information bit sequence having the first length.

**16.** The method of claim 13, wherein the encoder is a convolutional encoder.

**17.** The method of claim 13, further comprising the step of attaching error detection bits generated by a predetermined generator polynomial to the information bit sequence, and providing the error detection bit-attached information bit sequence, for encoding.

**18.** The method of claim 17, wherein an initial value of the predetermined generator polynomial is determined according to a frame length of the information bit sequence.

**19.** The method of claim 14, further comprising the step of attaching error detection bits to the information bit sequence, and providing the error detection bit-attached information bit sequence, for encoding.

**20.** The method of claim 19, wherein the information bit sequence having a frame length of the first length is an information bit sequence having the second slot length.

**21.** The method of claim 21, wherein the preset coding rate is 1/4.

**22.** The method of claim 19, wherein the error detection bits are generated by a predetermined generator polynomial.

**23.** The method of claim 22, wherein an initial value of the predetermined generator polynomial is determined according to a frame length of the information bit sequence.

PACKET DATA CONTROL
CHANNEL INPUT SEQUENCE
13 BITS
PER N SLOTS
(N=1,2, OR 4)

110

ERROR DETECTION
BIT ATTACHER

120

TAIL BIT
ATTACHER

130

CONVOLUTIONAL
ENCODER

140

SYMBOL REPEATER
FOR N=4

21 BITS

29 BITS

R=1/2
FOR N=1
AND R=1/4
FOR N=2 OR 4

58N SYMBOLS

170

MODULATOR

MODULATED
SYMBOL

160

INTERLEAVER

150

PUNCTURER

48N SYMBOLS
PER N SLOTS

48N SYMBOLS

FIG.1

EP 1 317 091 A2

FIG.2

EP 1 317 091 A2

FIG.3A

FIG.3B

FIG.4

FIG.5

FIG.6

FIG.7

CONTROLLER ~600

R

RECEIVED CODED SYMBOLS → CONVOLUTIONAL DECODER (R=1/4) → DECODED SYMBOLS

316,326

FIG.8

FIG.9